# EUROPEAN PATENT APPLICATION

(11) **EP 4 192 201 A1**
(43) Date of publication of application: **07.06.2023**
(21) Application number: 21212559.5
(22) Date of filing: 06.12.2021
(51) Int. Cl.: H05K 1/02, H05K 3/00, H05K 3/28

(54) **3D-SHAPED MODULE WITH INTEGRATED DEVICES AND METHOD**

(71) Applicant: NEDERLANDSE ORGANISATIE VOOR TOEGEPAST- NATUURWETENSCHAPPELIJK ONDERZOEK TNO, 2595 DA 's-Gravenhage (NL)
(72) Inventor: HARKEMA, Stephan, 2595 DA 's-Gravenhage (NL); TEUNISSEN, Jean-Pierre, 2595 DA 's-Gravenhage (NL)
(74) Representative: V.O.

(57) **Abstract**

Aspects of the present disclosure relate to a thermoformed structural electronics module 1 comprising integrated electronic devices 10 and a method of manufacturing thereof. The module can be manufactured by method comprising providing: a thermoformed stack including thermoplastic carrier substrate 3, electronic devices 10 with wiring and a buffer layer therebetween; and thermoforming 103 the stack at a plasticizing condition of the carrier substrate 3 and the buffer layer 2 whereby the thermomechanical buffer layer 2 comprises a thermoplastic composition having a storage modulus that is within 0.005% to 25%, preferably 0.01-10%, most preferably 0.02-2.5% of a storage modulus of the thermoplastic carrier substrate 3 during thermoforming.

## Description

### TECHNICAL FIELD AND BACKGROUND

The present disclosure relates to an electronics module and method of manufacturing. In particular present disclosure relates a structural module comprising one or more integrated electronic devices.

In-mould structural electronic parts are made available from a number of commercial suppliers. These part advantageously combine electronic functionality in a 3D-shaped module. Applications include car parts, human-interaction devices. During manufacturing these parts have gone through many heating steps and also a forming (shaping) step at high temperature and high pressure. At the various stages of processing, the combination of a mismatch between linear thermal expansion coefficients between the various components and application of pressure during thermoforming can cause stress between components resulting in structural defects and/or unacceptable cosmetic defects that are visible in the end product.

A way to mitigate defects can be to increase a thickness of a carrier substrate. This however increases costs of the device and increases the distance of between electronic components and an outer surface of the shaped device.

Alternatively it can be envisioned to provide electronic components after forming the product. This however complicates the manufacturing process, especially if the shaped includes components are thicker substrate and generally still requires rigid, i.e. thick substrates to support the devices and wiring during subsequent placing and bonding steps.

### SUMMARY

Aspects of the present disclosure relate to structural electronics module comprising one or more integrated electronic devices and to a method of manufacturing. Advantageously the method allows manufacturing of in-mould structural electronic devices that addresses one or more of the disadvantages of known methods in that devices can be formed having comparatively thinner front carrier substrates whereby formation of defects is effectively mitigated while retaining advantages as to structural integrity and ease of manufacturing, e.g. positioning of electronic components.

The module comprises a thermoformed stack. The stack is shaped in accordance with an outer face of a three-dimensional geometric shape of the structural electronics module. The shaped stack can be provided with a backing layer, yielding a three-dimensionally formed shaped module with one or more integrated electronic devices, e.g. a curved device. The module can advantageously comprise a variety of integrated electronic components that are protected between the front and backing layers. A non-limiting list of suitable electronic components includes: display or signage devices such as LED and/or OLED light guide or display arrangements; transceivers, sensors such as touch, pressure, temperature and/or proximity sensors, and actuators such as vibration generators.

The stack comprises a thermoplastic carrier substrate, one or more electronic devices and corresponding electronic wiring, and a thermomechanical buffer layer. Advantageously the electronic components can be commercially available surface mount type devices (SMDs), e.g. rigid components, mitigating a need to provide flexible electronic devices. In addition the modules can advantageously include electrical circuitry e.g. power supply tracks and/or electrical interconnections between devices and/or external terminals. The carrier generally defines a front face of the module. The buffer is arranged between the thermoplastic carrier substrate and the one or more electronic devices and corresponding electronic wiring.

Advantageously the module can be shaped according to a predefined three dimensional geometric shape whereby positioning of electronic components and wiring can be done prior to shaping, e.g. on planar substrates.

Advantageously the electronics module as disclosed herein can be formed as an integral unit with integrated electronic components while offering structural properties including self-supporting qualities at least during normal use.

The electronics module can for example be formed as a 3D-shaped car part or a part of a human interaction device. The module can for example be applied as part of a dashboard, a center console unit or a human interaction device having one or more integrated electronic devices.

The module can be formed by a method comprising: applying a thermomechanical buffer layer along a face of a thermoplastic carrier substrate; disposing, providing, one or more electronic devices and corresponding electronic wiring onto the buffer layer; and thermoforming the carrier substrate and the buffer layer with the integrated electronic device and corresponding electronic wiring disposed thereon. Advantageously the electronic components and wiring can be provided before forming, shaping, the carrier. Positioning the electronic components and wiring on a flat carrier provides a significant advantage in terms of manufacturability and/or reliability over alternatives that relying on providing the components post forming of the substrate.

During or before thermoforming, heat is applied to the stack for causing a temperature of the thermoplastic carrier substrate and buffer layer to raise above a processing temperature. The materials of the carrier substrate and buffer layer are selected such that the buffer layer is comprised of a thermoplastic composition having a storage modulus that is substantially lower, preferably by at least 50%, than the modulus of the carrier substrate during thermoforming. More specifically, the inventors surprisingly found that formation of defects while retaining essential functionality of the electronic devices and corresponding electronic wiring can be effectively mitigated when the buffer material has a storage modulus that is within a range of 0.005% to 25%, preferably 0.01%-10%, most preferably 0.02% to 2.5% of a storage modulus of the thermoplastic carrier substrate during the thermoforming. Additionally the device can advantageously be manufactured with comparative thin carriers substrates while synergistically combining the aesthetic benefits as disclosed herein with improving functionality by minimizing a distance between integrated electronic devices and an external face of the formed module.

Without being bound by theory, the mitigation of structural and cosmetic damage can be explained by the optimized mechanical properties, plasticity, of the buffer with regard to the carrier and electronic components over a temperature range encompassing temperatures during the thermoforming process and the provision of the electronic devices and the corresponding wiring.

In particular inventors find that the comparatively low storage modulus of the buffer relative to the carrier layer during thermoforming conditions allows it to deform more than the carrier and thus allows lowering mechanical stresses to the comparatively rigid electronic devices and corresponding wiring, which would otherwise transfer directly to the front substrate, and could cause defects such as visible deformations of the carrier and/or cracking of a functional interlayers such as a moisture barrier or a graphic pattern. At the same time inventors find that the lower limit of the storage modulus ensures that the buffer offers sufficient support to the components and the wiring during thermoforming to prevent loss of essential functionality, e.g. cracking of printed circuitry, by restricting plastic deformation under processing conditions.

So, by the synergetic combination of properties, the buffer layer can effectively mitigate both functional and cosmetic damages due to thermal and mechanical stress during the thermoforming process. The thicker the buffer layer, the stronger the mitigating effects can be. However from a functional point of view thinner buffer layers and carrier substrates are to be preferred as this allows to functional electronics components, e.g. sensors or display components, to be closer to an external front face of the module.

In a strongly preferred embodiment the module comprises a backing layer of a structural support material. The backing layer advantageously provides structural support to the thermoformed stack and encapsulates the one or more electronic device and at least part of the corresponding electronic wiring, thus protecting these electronic components from a backward direction while providing rigidity to the stack and the modulus as a whole, allowing the stack to advantageously be comparatively thin. A comparatively thin combined thickens of the stack advantageously reduces an overall contribution of carrier and/or buffer to the total modulus, and importantly, allows electronic devices, e.g. display or sensor, to be in close proximity from an external front face of the module. Advantageously carrier substrate and the buffer layer can have a combined thickness below 600 pm, or even below to 400 or 300 pm. In some embodiments the carrier can advantageously be as thin as about 350 or 250 pm optionally even less, e.g. 150-250 pm. The thickness of the buffer layer can be selected in accordance with a desired applications, whereby thicker layers increasingly reduce formation of cosmetic defects during manufacturing. Inventors surprisingly found that a thickness of the buffer layer in a range of 50 pm to 300 pm, or even 50-150 pm, suffices to mitigate both cosmetic and structural defects during manufacturing of the module.

Advantageously the backing layer can be directly provided along a backward face of the thermoformed stack opposite the carrier substrate, for example by applying a cure-able composition, e.g. by epoxy resin, along a back face of the preformed stack. Advantageously the backing layer can be provided by injection molding. In a preferred embodiment a thermoplastic polymer co mposition is injected in a space defined between an injection mould and the backward face of the thermoformed stack. Inventors surprisingly found that defects within the thermoformed stack can further be prevented even if a backing layer is applied to the thermoformed stack by injection moulding.

Inventors find that mitigation of defects formation during injection moulding is correlated to the buffer also having a minimal structural integrity during an injection moulding condition. In particular inventors found that buffer materials having a storage modulus of at least 0.01 MPa at 150 °C additionally effectively mitigate flow of the buffer layer during injection moulding conditions. Accordingly, and in relative terms, it was found that the storage modulus of the thermomechanical buffer layer is preferably in a range of 0.005-25 %, preferably within 0.01-10%, most preferably within 0.02%-2.5% of a storage modulus of the thermoplastic carrier during processing.

So, by the synergetic combination of properties, the buffer layer can effectively mitigate both functional and cosmetic damages during all relevant processing steps even including the injection moulding.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1A illustrates a stack prior to thermoforming;
FIG 1B illustrates aspects of manufacturing a thermoformed structural electronics module;
FIG 2A illustrates further aspects of manufacturing a thermoformed structural electronics module;
FIG 2B illustrates a thermoformed structural electronics module;
FIGs 3A and 3B provide views of comparative examples;
FIGs 4A-C illustrate thermoformed stacks and modules comprising defects; and
FIGs 5 to 10 provide illustrative experimental results.

### DETAILED DESCRIPTION

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

Storage modulus as mentioned herein can be determined using dynamic mechanical analysis (DMA) procedures in accordance with ISO 6721-11.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

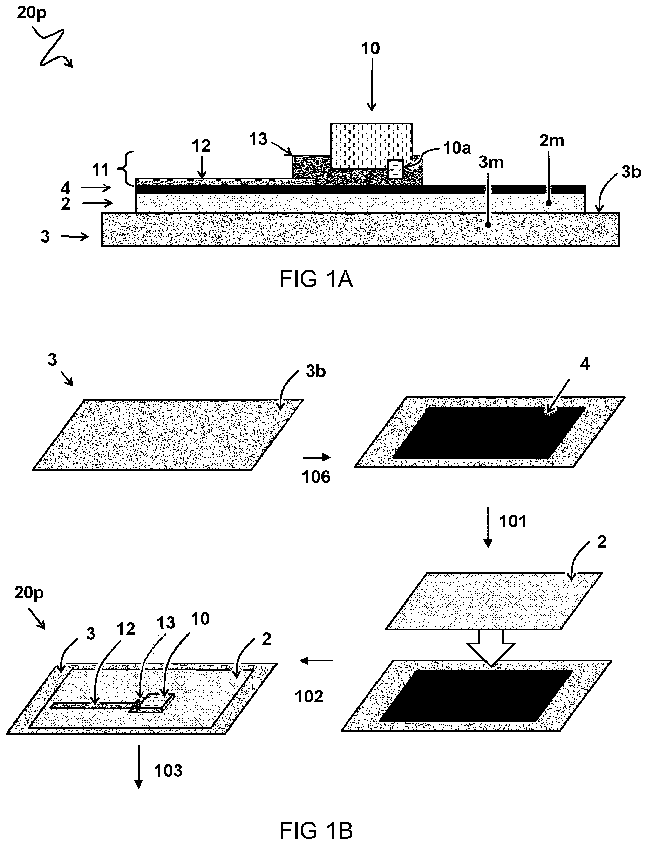

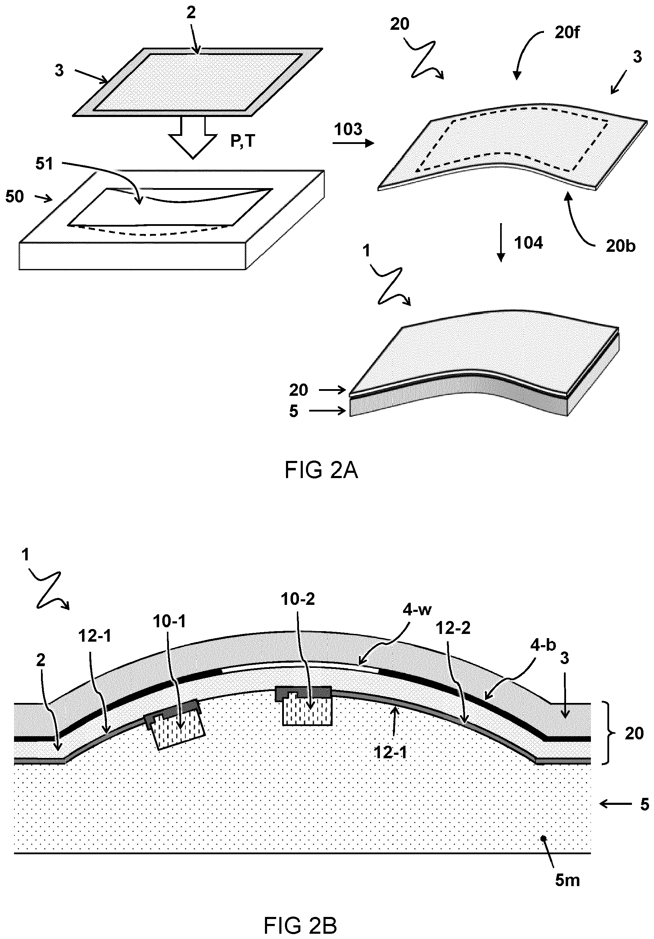

FIG 1A illustrates a planar (flat) stack 20p prior to thermoforming. FIG 1B and 2A illustrate aspects of embodiments of manufacturing of thermoformed structural electronics module, whereby FIG 1B illustrates aspects relating to manufacturing prior to thermoforming the stack and FIG 2A illustrates aspects relating to the thermoforming and provision of a backing layer. FIG 2B illustrates a structural electronics module 1 including a thermoformed stack 20 supported by backing layer 5.

Some aspects of the present disclosure relate to the manufacturing of a curved device 1. For example, (out-of-plane) curvature can be introduced by applying a deformation process to a planar stack 20p. Preferably, the deformation process comprises thermoforming. For example, the deformation process comprises applying a predefined macroscopic shape, e.g. a mould, to the stack for thermoforming of the stack. Thermoforming is generally understood as a manufacturing process where a substrate of a thermoplastic (thermosoftening plastic) material is heated to a pliable forming temperature. Typically, above its glass transition temperature (Tg) and below its melting point, the physical properties of a thermoplastic change drastically without an associated phase change. The heated substrate can be formed to a specific shape e.g. using a mold, and trimmed to create a usable product. Typically, the stack is heated to a high-enough temperature that permits it to be stretched into or onto a mold 50, as shown in FIG 2A, and cooled to a finished shape.

A particular preferred version of thermoforming is also known as High Pressure Forming. Another version of thermoforming is known as vacuum forming which however may require higher temperatures. For example, a machine can be used to heat the stack and stretch it over a mold using high pressure and/or vacuum. This method is typically used for sample and prototype parts. In other or further applications, production machines can be utilized to heat and form the substrate and optionally trim the formed parts from the stack in a continuous high-speed process. Alternatively, or in addition to thermoforming, also other deformation processes can be used for application of the present teachings such as injection molding, blow molding, rotational molding and other forms of processing plastics at elevated temperatures. So where reference herein is made to a thermoforming process or temperature, this may also be applicable to other similar processes. In some embodiments, e.g. as shown in FIG 2B, a backing layer 5 is applied onto a back side 20b of the stack by injection molding, e.g. using a mould. For example, a thermoplastic material is melted and injected between a mold 22 and the stack. Alternatively, or in addition, a thermosetting material or curable composition, e.g. an epoxy resin, can be applied to a back face of the stack.

In one embodiment, e.g. as shown e.g. in FIG 1A, the stack 20p comprises a thermoplastic carrier substrate 3. In addition the stack includes one or more electronic devices 10 along with corresponding electronic wiring 11. A thermomechanical buffer layer is arranged along a face, a backward face, 3b of the thermoplastic carrier substrate 3 between the thermoplastic carrier substrate and the one or more electronic devices 10 and corresponding electronic wiring. Both the buffer layer 2 and the carrier substrate 3 are respectively comprising, or essentially consist of, respective thermoplastic compositions 2m, 3m, which as explained in more detail are not identical, but are purposefully selected to have different physical properties during thermoforming. Optionally the buffer can be formed of a stack of buffer layers, for example a stack including a layer of a composition with poor adhesive strength for the carrier and an adhesive interlayer. Inclusion of an adhesive interlayer advantageously broadens the range of usable buffer materials to materials having suitable thermomechanical properties as specified herein but with a comparatively poor/weak adhesion to carrier and/or graphic layer disposed thereon. Optionally, an additional, e.g. local, graphic layer, buffer layer and/or adhesive layer can be applied to better adhere the layers and/or cover the SMD and/or or other components.

The electronic wiring 11 generally includes one or more electronically conductive tracks 12 and conductive interconnects 13, bonds, interconnecting the wiring to the electronic device 10. The wiring, also referred to as circuitry, can be provided by additive or subtractive manufacturing methods known including, printing methods, forward transfer and micro patterning. As shown the conductive interconnects 13 include an underfill portion providing an electrically conductive connection to a bond pad portion 10a of the electronic device 10.

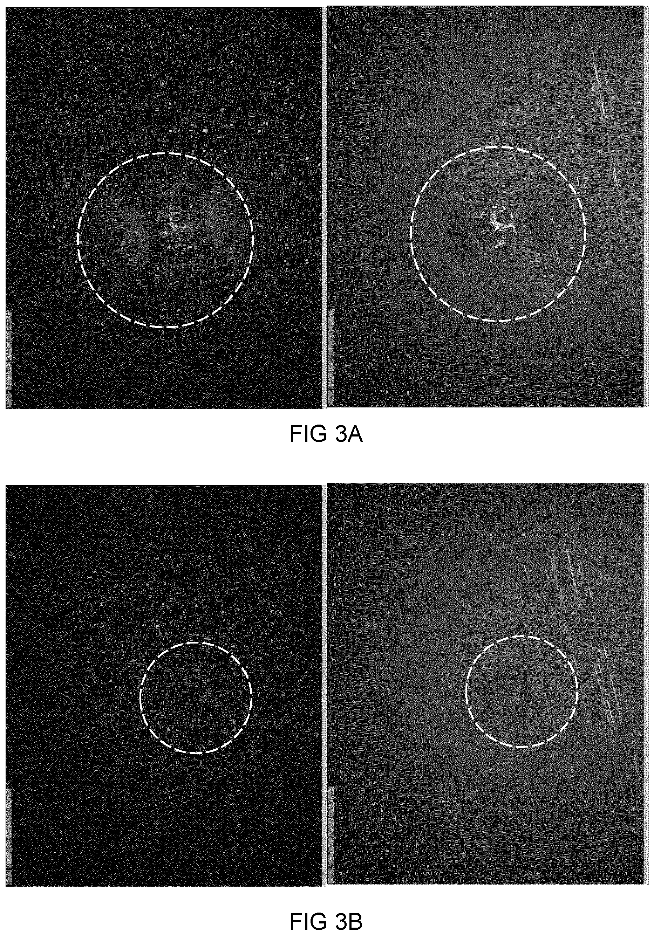

As will be explained in more detail under reference to FIGs 2A and 2B the stack will be thermoformed, shaped, in a non-planer curved geometry, typically in accordance with an outer face of a geometric shape of the structural electronics module. As shown in FIG 3B, the carrier substrate 3 can define, or even constitute an exterior face of the electronics module 1 with direct visibility to an end-user. To minimize rejects, it is important to mitigate both structural and visible, e.g. aesthetic, defects during manufacturing.

As described herein, the thermoplastic material 2m comprised in the buffer preferably has a storage modulus (G2) that is at least 75% lower than the storage modulus (G3) of the composition 3m of carrier substrate during thermoforming, preferably at least 90% lower, most preferably at least 97.5% lower, than the modulus of the carrier substrate during thermoforming (G2/G3 < 0.5, preferably <0.1). More specifically, the buffer material has a storage modulus that is within a range of 0.0005% to 25%, preferably within 0.01% to 10%, most preferably 0.02%-2.5% of a storage modulus of the thermoplastic carrier substrate during the thermoforming. In practical thermoforming conditions, the inventors found that the carrier preferably has a storage modulus in a range of 10-100 MPa during thermoforming. Thermoforming conditions generally include an appropriate combination of pressure and thermoforming temperature, whereby the pressure is generally in a range of 10-100 bar, more particularly 30-70 bar. For polycarbonate (PC) based carriers, pressure is typically 40-60 bar, and temperature is typically between 145-165°C, at which the storage modulus is between about 10 MPa and about 50 MPa. For a G' of 50 MPa, this means that the lower limits of 0.01 and 0.02% for the storage modulus (G2) respectively correspond to ≥ 0.005 MPa and ≥ 0.01 MPa. An upper limit of 25% and 10% respectively correspond to a modulus ≤ 12.5 MPa and ≤ 5 MPa, at 150°C. For other carriers/materials, e.g. PMMA-based corresponding parameters can be easily determined, e.g. by dynamic mechanical analysis (DMA) over a temperature range encompassing thermoforming conditions. For other carrier materials, e.g. PVC, PMMA, etc, inventors find that thermoforming is performed under conditions offering similar pliability, e.g. by heating the material whereby the storage modulus is in the range 10-100 MPa, preferably 10-40 MPa. The exact thermoforming temperature depends on properties of the material and can be determined experimentally. Thermoforming is performed at a temperature (Tf) in a range from 20 degrees below to 20 degrees above a glass transition temperature (Tg) of a carrier/material (Tg-20 ≤ Tf ≤ Tg+20). To avoid flow, the thermoforming temperature is preferably below a melting transition of the carrier.

Preferred carrier substrates include compositions that can be thermoformed, plastically deformed, at a pressure range of 10-100 bar, more particularly 30-70 bar. Typically, the first thermoplastic material 11m has a glass transition temperature below 160 °C, preferably below 150 °C. The buffer (thermoplastic composition 2m) has a glass transition temperature well below that of the carrier, typically by at least ten degrees lower.

Suitable carrier materials include, but are not limited to, polycarbonate (PC) based compositions, poly(methyl methacrylate) (PMMA) based compositions, ABS (acrylonitrile butadiene styrene), PETG (a thermoformable version of polyethylene terephthalate), PVC (polyvinyl chloride), bio-based PC and polyethylene furanoate (PEF) compositions, et cetera.

Similar to the carrier the buffer comprises, or essentially consists of a thermoplastic composition 2m. In some embodiments, the buffer comprises of a thermoplastic elastomer. Thermoplastic elastomers (TPE), sometimes referred to as thermoplastic rubbers, are a class of copolymers or a physical mix of polymers (usually a plastic and a rubber) that consist of materials with both thermoplastic and elastomeric properties.

In a preferred embodiment, the buffer comprises thermoplastic polyurethane (TPU), or Polyvinyl butyral (PVB). So for example a combination of PMMA and TPU can be thermoformed at a processing temperature around 100-130 °C while a combination of PC and TPU can be thermoformed at a processing temperature around 145-165 °C.

In some preferred embodiments, particularly for automotive applications, the carrier substrate 3 (the front substrate) is made of polycarbonate (PC), which is a generally accepted industry-standard material. For other applications, particularly outside the automotive industry, other compositions may be preferable. For example, PMMA or ABS may be more preferable for hand held user interface devices.

In some embodiments, the second thermoplastic material 12m comprises a thermoplastic elastomer. Thermoplastic elastomers (TPE), sometimes referred to as thermoplastic rubbers, are a class of copolymers or a physical mix of polymers (usually a plastic and a rubber) that consist of materials with both thermoplastic and elastomeric properties. For example, the second thermoplastic material 12m substantially softens when heated to temperatures which are substantially above room temperature, e.g. softening in a range between 80 - 140 °C. In a preferred embodiment, the second thermoplastic material 12m comprises thermoplastic polyurethane (TPU) or Polyvinyl butyral (PVB). So for example a combination of PMMA and TPU can be thermoformed at a processing temperature around 100-130 °C while a combination of PC and TPU can be thermoformed at a processing temperature around 145-165 °C.

In some preferred embodiments, the thermoplastic carrier substrate 3 and the buffer layer 2 are transparent or at least translucent, e.g. smoked or hazy. This allows propagation of light to towards and/or from one or more of the electronic devices, e.g. outward propagation of visible light from a display arrangement and/or inward propagation of light, e.g. IR-light, towards a sub and embedded sensor.

In one embodiment, e.g. as shown in FIG 1B, the method comprises applying 101 a thermomechanical buffer layer 2 along a face 3b of a thermoplastic carrier substrate 3. The inventors find in particular that a relatively thin buffer layer can be reliably applied by printing, e.g. with thickness below 20 µm, below 10 µm, down to 5 µm. Thicker layers, e.g. layers >20 µm, are preferably applied by laminating one or multiple foils, having an appropriate thickness, onto the carrier.

In some preferred embodiments, the method further comprises applying 106 a graphic layer 4. In some embodiments, e.g. as shown, the pattern is applied to the face 3b of carrier substrate prior to deposition of the buffer. Alternatively, or in addition, a graphic pattern can be applied onto the buffer layer, e.g. directly after its deposition or prior to its lamination to the carrier. The graphic layer 4 can advantageously define a graphic pattern in accordance with a position of at least one of the electronic devices to be disposed. Depending on the application the graphic layer may be configured to hide underlying electronic components and/or wiring from view, e.g. a continuous black layers as shown. Alternatively or in addition the graphic layer or parts thereof may be configured to draw attention to a position of an underlying components, e.g. a pattern indication a position or perimeter of an underlying sensor or human interaction component.

Of course the method can comprise deposition of one or more other layers, e.g. a scratch resistant layers, a non-stick surface finish, and/or a matt/glossy surface layer, so long as these layers do not substantially affect the thermoforming properties of the stack. Depending on function these layers can be provided on one or more faces of the carrier and/or buffer layer, e.g. an outward face of the carrier opposite a face receiving the buffer. Of course such layers can also be provide, e.g. sprayed, onto the module after thermoforming.

The one or more electronic devices 10 and corresponding electronic wiring 11,12,13 are disposed 102, positioned, onto the buffer layer 2. For some components it can be preferred to print these. Preferably, the circuit lines 12 are printed on the thermomechanical buffer layer 2. For example, the circuit lines 12 are printed using conductive ink, e.g. comprising silver (Ag), preferably printed on the buffer layer 2 after it is laminated to the carrier 3 but before thermoforming. The printed lines 12 generally require thermal curing to impart final electrical conductivity. Typically the circuit lines are cured prior to deposition of the electronic devices 10. Also other components are preferably applied between the lamination and thermoforming steps, although these processes can in principle also be applied to the buffer layer 12 before lamination. Typically, the circuit lines are electrically connected to electronic components disposed on the buffer layer 12. For surface mount devices the interconnection to the wires, e.g. printed tracks, is preferably realized by an electrically conductive adhesive composition. These and other components may be connected to an electric circuit comprising circuit lines 12 (e.g. printed) on the buffer layer 2, on the front carrier substrate 3, and/or via vertical interconnects through the buffer layer 2 and/or further layers such as an optional backing layer 5. Typically an isotropic conductive adhesive (ICA) composition 13, which can be deposited onto the wiring and/or electrical interconnects, e.g. feet 10a, of the electronic device 10. Inventors found that the combination of carrier and buffer layer as disclosed herein allows thermal curing of the wiring and/or ICA at typical temperatures up to at most 120°C until a desired conductivity level is achieved. Preferably curing is performed at a lower temperature, e.g. about 70-90 °C. Optionally, circuitry and adhesive can be cured simultaneously, in one step, reducing a total thermal heat exposure of the buffer as comparted to a method involving two separate curing and application steps. Reducing temperature can improve visual appearance of the stack. Preferably, the ICA is a comparatively soft, e .g. rubbery, material, e.g. a silicone based-ICA. Silicone-based ICA materials were found to mitigate transfer of mechanicals stress between carrier and device during thermoforming.

Following deposition of the buffer and electrical components the stack is subjected to thermoforming 103 and optional, but strongly preferred, provision of a backing layer 5. Fig 2A schematically illustrates these aspects of manufacturing a thermoformed structural electronics module. A stack 20p comprising a thermoplastic carrier substrate 3, one or more electronic devices and corresponding electronic wiring (not indicated), and a thermomechanical buffer layer 2 between the thermoplastic carrier substrate and the one or more electronic devices, e.g. as obtainable following the steps as discussed in relation to FIG 1B, positioned across a mould 50 having portion 51 that is geometrically shaped in accordance with an outer surface of the structural electronics module to be formed. Under application of heat and pressure (T,P) the stack 20p is formed to 3D-thermoformed stack 20, shaped in accordance to the mould. Heat for can be appropriately provided by one or more of radiative heat (IR irradiation) or direct contact, e.g. via a wall of the mould. Pressure, e.g. a vacuum between mould 50 and carrier and/or overpressure acting onto the stack from the buffer layer can be suitably applied to assure compliance/contact of the stack and the mould.

To minimize heat load on the devices, wiring, and/or buffer the heat during moulding it is preferable to preferentially heat from a forward direction onto the carrier, e.g. by preferential irradiation from a direction onto the carrier over irradiation from a direction onto the buffer and/or supplying a predominant potion of the heat, or even exclusively, by heating portions of the mould that face the carrier and not heating, or even cooling portions of the mould facing the buffer. Accordingly, a temperature gradient can be established within the stack whereby temperature of the carrier can be higher than a temperature at the buffer layer and the conductive tracks and components disposed thereon. Inventors experimentally confirmed that during thermoforming, a temperature at a buffer-side of a stack can be 10 degrees lower than a temperature at a carrier side of the stack when the stack is heated from the carrier side (single side heating). This allows the buffer to retain a comparatively higher modulus during thermoforming conditions.

Upon thermoforming 103 a 3D-shaped stack is realized which electronic components 10 and wiring 11 disposed along a backward face thereof. In the figure stack 20 is depicted from a direction looking onto a forward face 20f the stack 10. The positions of buffer and electronic components along a backward face 20b, opposite the carrier is indicated by a dashed box.

In some embodiments, the method comprises outgassing the thermomechanical buffer layer 2. For example, by subjecting the buffer to elevated temperatures e.g. 80-100°C, optionally at reduced pressure, e.g. below 0.1 bar. Outgassing the buffer reduces an amount of volatiles, e.g. water or solvent residues, which may cause bubble formation or other inconsistencies during processing subsequent processing steps at elevated temperature, e.g. curing, and/or thermoforming. Preferably outgassing is performed after deposition of the buffer layer onto the carrier prior to disposing the electronic components and/or wiring. Alternatively, or in addition, outgassing can be performed just prior to thermoforming and/or prior to injection moulding, e.g. to remove volatiles that may have (re-)entered the buffer during storage of parts between processing steps. Alternatively or additionally sheets of buffer material can be outgassed prior to lamination.

After thermoforming there is an optional, but strongly preferable, step of providing 104 a backing layer 5. As shown in FIGs 2A and 2B the backing layer 5 is provided along the backward face 20b of the stack. The backing layer encapsulates the one or more electronic devices 10-1, 10-2 and at least part of the corresponding electronic wiring 12-1, 12-2.

The backing layer 5 is formed of structural support material 5m which imparts rigidity to the stack and protects the electronic devices 10 and wiring from a backward direction, yielding an 3D-shape, module, with integrated electronic functionality, whereby thermoforming and electric components have minimal effect on an outer appearance, e.g. aesthetic.

In a preferred embodiment, the backing layer is formed of a thermoplastic material 5m. Advantageously the backing layer can be applied by back side injection moulding. Injection moulding is a well-known method enabling formation of rigid components in a broad variety of geometric shapes. Generally injection moulding comprises forcing a plastic material heated to a molten state into a mould. After cooling a rigid product can be obtained whereby the mould can define a geometric shape of product. Accordingly, in a preferred embodiment, the method comprises injection molding thermoplastic polymer composition in a space defined between an injection mould and the backward face 20b of the thermoformed stack 20.

For a combined mitigation of defects formation under thermoforming and injection moulding the thermomechanical buffer layer 2 has a modulus in excess of 0.005 MPa at 150°C. Preferably, the buffer layer 2 has a higher modulus ≥ 0.01 MPa at 150 °C. Materials having a higher modulus (as indicated by a modulus at 150°C) are more resilient to deformations during injection moulding. Accordingly, in some embodiments, the buffer has a modulus ≥ 0.13 MPa at 150°C or even a modulus ≥ 0.14 MPa at 150°C.

Accordingly, in a preferred embodiment the method comprises a providing 104 a backing layer 5 of a structural support material 5m along a backward face 20b of the thermoformed stack 20 opposite the carrier substrate 3, said backing layer encapsulating the one or more electronic device 10 and at least part of the corresponding electronic wiring 11.

Preferably, providing the backing layer 5 comprises injection molding a thermoplastic polymer composition 5m in a space defined between an injection mould and the backward face 20b of the thermoformed stack 20. It will be appreciated that when the backing layer 5 is provided by backside injection moulding, the buffer material 5m is preferably selected to have a modulus G2 in a range of 0.005-25%, preferably 0.01-10%, most preferably 0.02%-2.5% of the modulus (G3) of the carrier over a temperature range encompassing the thermoforming. The polymer composition 5m forming the backing layer is generally heated to a temperature in a range of 280-320°C. Of course the mould and stack therein are not heated to this temperature. Despite the high temperature of the injected material inventors surprisingly found that the stack and in particular the buffer, can essentially remain sufficiently solid to support for the components and circuitry if the buffer material 3m is selected to have a modulus as specified herein. In particular inventors found no appreciable structural or visible damages in the formed structural electronics module 1 when the buffer material has modulus ≥ 0.01 MPa at 150°C.

As an alternative to injection moulding the backing layer can be applied by casting, e.g. vacuum casting or flow casting a curable or thermosetting liquid composition. Casting advantageously imparts reduced forces and/or thermal load onto the buffer as compared to injection moulding. The backing layer can thus comprise, or essentially consist of, a composition, e.g. an epoxy resin, that cures/sets around room temperature, e.g. within a range of 25-60°C, which reduces a thermal load onto the electronic components, wiring, and/or buffer layer. However, in contrast to injection moulding, casting generally requires subsequent processing, e.g. addition of subsequent layers, to define a backside geometry of the structural electronics module 1. As such casting of a thermosetting or curable composition can be particularly preferred when the buffer has a modulus in a range of 0.005 and 0.02% of modulus of the carrier.

FIG 2B schematically depicts an embodiment of a structural electronics module 1 as obtained after thermoforming and injection moulding 104 of a backing layer 5 comprised of a thermoplastic composition 5m. The device as shown includes two electronic devices 10-1,10-2, each connected by respective wiring 12-1,12-2. As shown, the graphic layer includes a pattern comprising two different portions 4-b and 4-w. The first potion 4-b is a layer of non-transparent or opaque material, e.g. black ink, that hides the under lying device 10-1 and wiring from view. The second portion 4-w is a transparent or at least translucent portion or even a window that allows light propagation to/from device 10-2. A rigid backing layer 5 of a structural support material 5m provided along a face of thermoformed stack opposite the carrier substrate encapsulates the electronic devices 10-1,10-2 and at least part of the corresponding electronic wiring while providing structural support to module 1.

In particular embodiments, wherein the carrier substrate 3 is formed of a composition comprising polycarbonate, the module can be applied as a car part. Preferably, the buffer layer is formed of a composition comprising TPU or PVB. More preferably the carrier and the buffer layer have a combined thickness in a range of 300-600 µm. Most preferably the buffer layer is formed of a composition comprising TPU or PVB, the carrier and the buffer layer have a combined thickness in a range of 175-250 pm.

### Experimental results

The invention will now be further illustrated with reference to the following non-limiting examples.

In mixing and matching various combinations of carriers and buffer materials inventors have tested numerous different carrier materials and buffer materials as well as combinations thereof and their effect on mitigating both structural and visible damages in the manufacturing of 3D-shaped structural electronics modules. In particular inventors found that for all tested combinations visual and structural defects due to thermoforming were mitigated when the storage modulus of the buffer material was within 0.005%-25%, preferably 0.01% and 10%, more preferably 0.02%-2.5% of the storage modulus of the carrier during thermoforming.

Samples were compared to thermoformed modules without buffer layer for different thicknesses of the carrier, in particular 250 pm and 500 pm thick films of polycarbonate, whereby thinner carriers showed more profound defects and thicker substrates show less profound, yet still clearly visible, defects. Other carriers/compositions yield similar results.

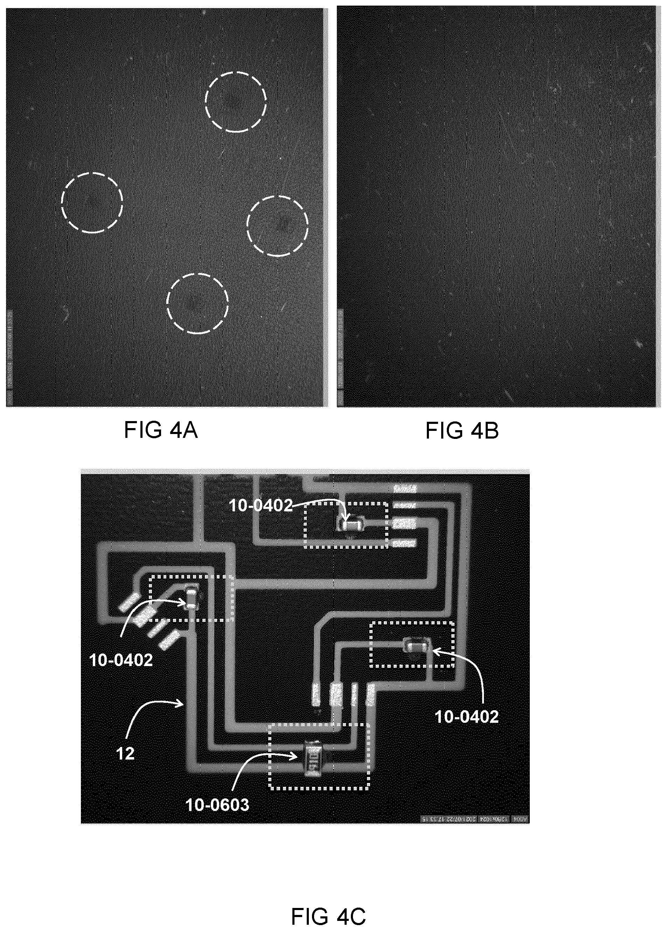

FIG 3A and B and 4A provide photographs of a SMD device (Chip) bonded along 250 pm PC carrier substrate as seen through the carrier layer in absence of any buffer layer prior to thermoforming, whereby images in FIG3A illustrate examples cured at 120°C and FIG 3B relates to samples otherwise similar samples but cured at 80 °C. Micrographs on the left are obtained with polarized light, micrographs on the right with unpolarized light. As can be seen from the figures, visual defects at a position of the chip (marked by circle) are clearly identifiable, even before thermoforming. Although curing at 80°C somewhat reduces defects, both are already considered rejects even more so after thermoforming, which further increases visibility. Wiring formed of cured Ag-ink (ME604 as obtainable by DuPont or Ag-ink Elepaste TR 70901 as obtainable by Taiyo) is less pronounced at least prior to thermoforming. FIG 4A illustrates that comparable issues exist for PC samples with a total thickness of 500 µm.

FIG 4B depicts a micrograph of a sample (see S27 for detail) including wiring and devices as disposed onto a PVB-based buffer layer. As shown visible defects are virtually absent prior to thermoforming. Other buffers according to the invention shown comparable results.

FIG 4C provides a view from a backward direction (buffer side) of the electronic device 10 and corresponding electronical interconnecting wiring as used for testing. As shown two different types of SMD devices, marked 10-0402 and 10-0603 (Franell, 0402: 0.1 µF ceramic capacitor case and 0603: resistor case) were tested. Wiring 12 was formed of a Ag-ink (Taiyo, TR 70901).

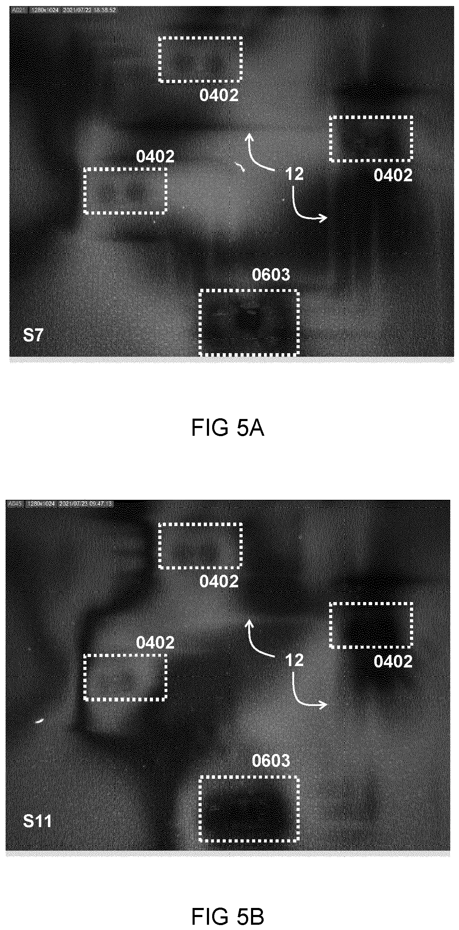

FIGs 5-8 depict optical micrographs of comparative samples and views of regions of several illustrative examples of thermoformed stacks. All micrographs were obtained under identical conditions (polarized light). All samples were thermoformed under similar conditions unless specified otherwise. Reported storage modulus values were determined with DMA in accordance with ISO 6721-11. Visibility of defects as discussed herein below under polarized light is indicative of a final score of defect visibility. However scoring (scale 1-5) also includes visual observations under non-polarized light and under glancing angles, which are difficult to reproduce on paper. As used herein below of score of 1 indicates poorest performance. A score of 5 indicates best performance, whereby scores of 1-2 are generally rejects.

FIG 5A relates to a comparative example S7, comprising a 250 pm PC substrate, no buffer, curing was at 120°C. Tracks were formed from Taiyo silver ink, cured at 120 degrees 10 minutes, SMD bonding with ICA and underfill, cured at 120 degrees for 10 minutes each. Thermoforming was performed at 151.5 °C on average with single sided heating.

FIG 5B relates to a comparative example S11 which is identical to S7 except that curing was at 80°C. Tracks were formed from Taiyo silver ink, cured at 80 °C for 10 minutes, SMD bonding with ICA and underfill, cured at 80 °C for 30 min, resp 1 hour. Thermoforming was performed at 150.0 °C on average with single sided heating.

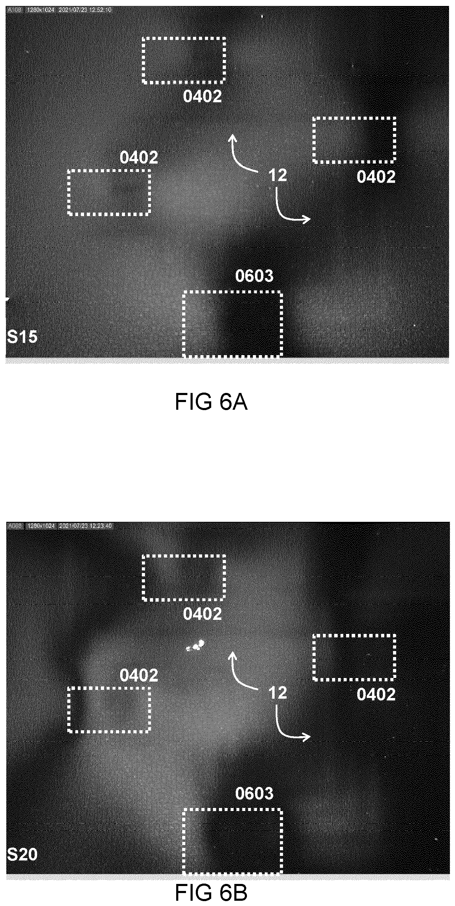

FIG 6A relates to an example S15 comprising a 70 pm polyester-based TPU buffer with G'∼ 1 10⁻⁴ MPa at 150°C. Total thickness of buffer and PC is 320 pm. Tracks were formed from Taiyo silver ink, cured at 80 °C for 10 minutes, SMD bonding with ICA and underfill, cured at 80 °C for 30 min, resp 1 hour. Thermoforming was performed at 149.5 °C on average with single sided heating. As compared to comparative samples S7 and S11 visibility of SMD devices and wiring is significantly reduced

FIG 6B relates to an example S20 comprising a 90 pm polyester-based TPU composite buffer with G'∼ 1.5 10⁻² MPa at 150°C. Total thickness of buffer and carrier is 340 pm. Tracks were formed from Taiyo silver ink, cured at 80 °C for 10 minutes, SMD bonding with ICA and underfill, cured at 80 °C for 30 min, resp 1 hour. Thermoforming was performed at 148 °C on average with single sided heating. As compared to comparative samples S7 and S11 visibility of SMD devices and wiring is significantly reduced. As compared to S15 visibility of silver lines and chip-0402 is somewhat reduced.

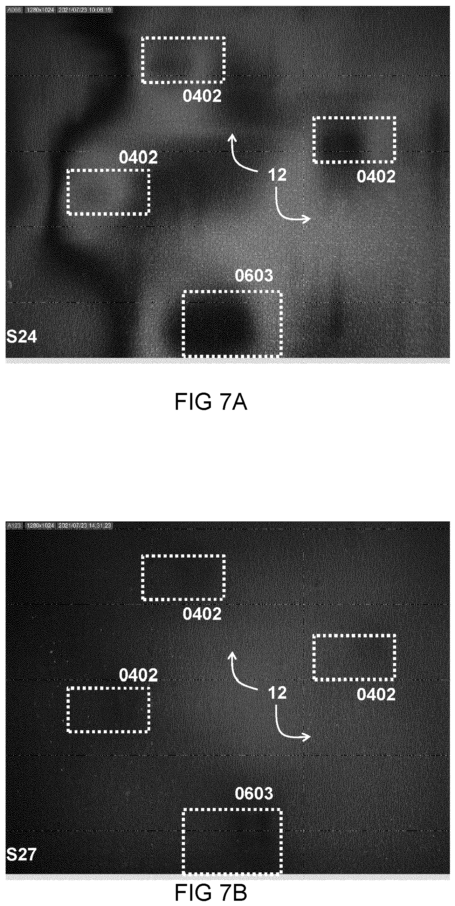

FIG 7A relates to an example S24 comprising a 100 pm polyether-based TPU buffer with G' ∼ 2.5 10⁻¹ MPa at 150°C. Total thickness of buffer and PC is 350 pm. Tracks were formed from Taiyo silver ink, cured at 80 °C for 10 minutes, SMD bonding with ICA and underfill, cured at 80 °C for 30 min, resp 1 hour. Thermoforming was performed at 154 °C on average with single sided heating. As compared to comparative samples S7 and S11 visibility of SMD devices and wiring is significantly reduced. As compared to S20 and S15 visibility of Ag-lines is similar whereas visibility of SMD devices scores acceptable yet somewhat poorer.

FIG 7B relates to an example S27 comprising a 260 pm PVB-based buffer with G' ∼ 1.4 10⁻¹ MPa at 150°C. Total thickness of buffer and PC is 510 µm. Tracks were formed from Taiyo silver ink, cured at 80 °C for 10 minutes, SMD bonding with ICA and underfill, cured at 80 °C for 30 min, resp 1 hour. Thermoforming was performed at 145 °C on average with single sided heating. As compared to comparative samples S7 and S11 and samples S15, S20, and S24 visibility of SMD devices and wiring is significantly reduced.

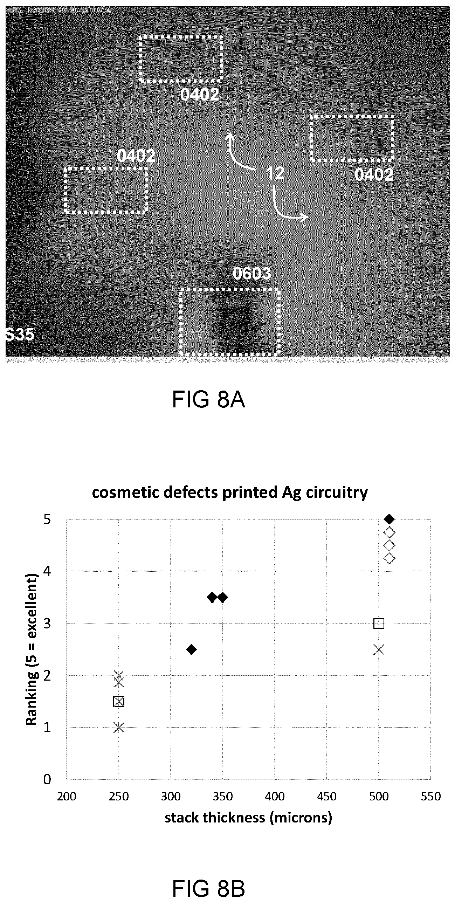

FIG 8A relates to a comparative example S35 with a thickness equivalent of 2 layers of PC with a thickness of 250 pm. Tracks were formed from Taiyo silver ink, cured at 80 °C for 10 minutes, SMD bonding with ICA and underfill, cured at 80 °C for 30 min, resp 1 hour. Thermoforming was performed at 157.5 °C on average with single sided heating. As shown wiring-related defects are reduced relative to a single layer of PC. However, SMD-related defects are insufficiently mitigated, despite using a thicker (and twice as expensive) PC substrate (note comparatively poor contrast due to very high contrast of 0603-type device).

FIG 8B presents a summary of defects scores relating to visibility of silver wiring after thermoforming. Entries marked with diamonds relate to samples according to the invention. Entries marked with a closed diamond (block) correspond to curing at 80°C. Entries marked with open diamonds (red) correspond to curing at 120°C. Entries marked with a cross and open square are comparative (without buffer). As shown, use of low curing temperatures, and incorporation of a buffer layer each effectively reduce visibility of silver-track related defects at a comparable or lower overall thickness, with the combination of buffers and low T curing offering best performance.

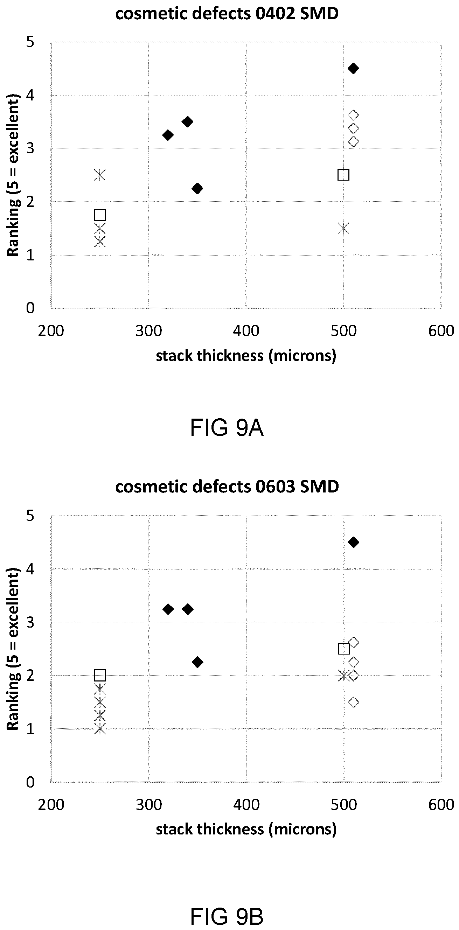

FIG 9A presents a summary of defects scores relating to visibility of 0402-typetype SMD devices after thermoforming. Entry marking is in line with FIG 8B. As shown incorporation of a buffer layer effectively reduces visibility of SMD-related defects at a comparable or lower overall thickness. Lower curing temperatures have increased performance.

FIG 9B presents a summary of defects scores relating to visibility of 0603-type SMD devices after thermoforming. Entry marking is in line with FIGs 8B and 9A. As shown incorporation of a buffer layer effectively reduces visibility of SMD-related defects at a comparable or lower overall thickness. Lower curing temperatures have increased performance.

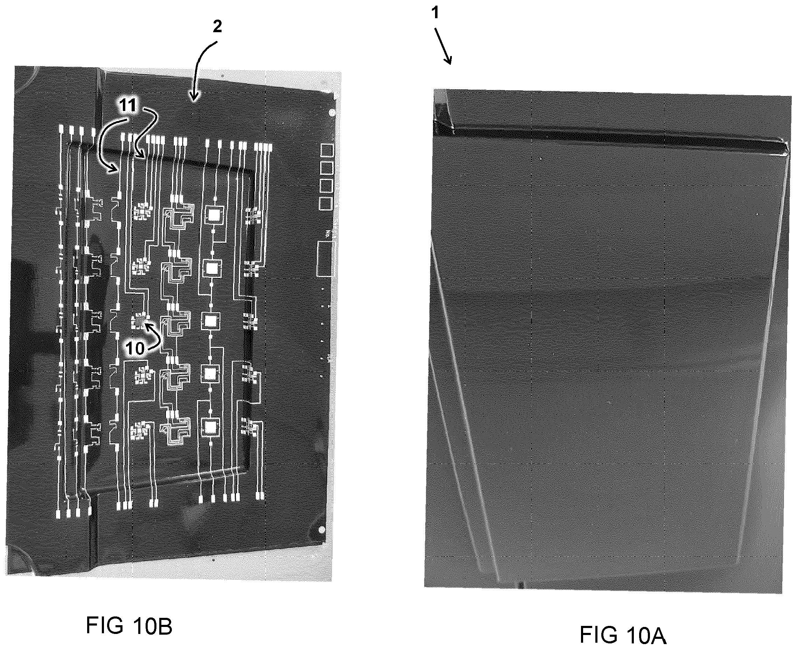

FIG 10A and B depict photographs of a thermoformed structural electronics module 1 that can be used as part of human interaction device in a car. FIG 10B provides a rear view showing the wiring 11 and devices 10 along the buffer layer 2 prior to provision of the backing layer. FIG 10A provides a front view (rotated) of the same part prior to application of a backing layer. As shown defects are essentially indiscernible, despite unforgiving is illumination under glancing angles.

For the purpose of clarity and a concise description, features are described herein as part of the same or separate embodiments, however, it will be appreciated that the scope of the invention may include embodiments having combinations of all or some of the features described. Of course, it is to be appreciated that any one of the above embodiments or processes may be combined with one or more other embodiments or processes to provide even further improvements in finding and matching designs and advantages.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A method (100) of manufacturing a thermoformed structural electronics module (1) comprising one or more integrated electronic device (10), the method comprising:
applying (101) a thermomechanical buffer layer (2) along a face (3b) of a thermoplastic carrier substrate (3);
disposing (102) the one or more electronic device (10) and corresponding electronic wiring (11) onto the buffer layer (2);
thermoforming (103) the carrier substrate (3) and the buffer layer (2) with the integrated electronic device (10) and corresponding electronic wiring (11) disposed thereon to a thermoformed stack (20) in a mould under application of pressure and heat at a plasticizing condition of the carrier substrate (3) and the buffer layer (2) and
wherein the thermomechanical buffer layer (2) is comprised of a thermoplastic composition (2m) having a storage modulus that is within a range of 0.01% to 10% of a storage modulus of the thermoplastic carrier substrate (3) during the thermoforming.

2. The method according to claim 1, further comprising a providing (104) a backing layer (5) of a structural support material (5m) along a backward face (20b) of the thermoformed stack (20) opposite the carrier substrate (3), said backing layer encapsulating the one or more electronic device (10) and at least part of the corresponding electronic wiring (11).

3. The method according to claim 1 or 2, wherein providing the backing layer (5) of a structural support material (5m) comprises injection molding thermoplastic polymer composition in a space defined between an injection mould and a backward face (20b) of the thermoformed stack (20) and wherein the thermomechanical buffer layer (2) has a modulus in a range of 0.02 - 2.5% of a storage modulus of the thermoplastic carrier substrate (3) during thermoforming.

4. The method according to any of the preceding claims, wherein the method comprises outgassing the thermomechanical buffer layer (2) prior to the thermoforming

5. The method according to any of the preceding claims, wherein the pressure during thermoforming is in a range of 30-70 bar and wherein the temperature during thermoforming is in a range of 145-165°C.

6. The method according to according to any of the preceding claims, wherein the method further comprises, prior to applying the buffer layer, applying (106) a graphic layer (4) onto the face (3b) of carrier substrate (3) defining a graphic pattern in accordance with a position of at least one of the electronic devices to be disposed.

7. A structural electronics module (1) comprising:
a thermoformed stack (20) comprising
a thermoplastic carrier substrate (3),
one or more electronic devices (10) and corresponding electronic wiring, and
a thermomechanical buffer layer (2) arranged along a face (3b) the thermoplastic carrier substrate (3) between the thermoplastic carrier substrate and the one or more electronic devices (10) and corresponding electronic wiring (11),
wherein the thermomechanical buffer layer (2) is comprised of a thermoplastic composition (2m) having a storage modulus (G2) within a range of 0.01% to 10% of a storage modulus (G3) of the thermoplastic carrier substrate (3) over a temperature range encompassing a thermoforming temperature of the thermoformed stack (20).

8. The structural electronics module (1) according to claim 7, further comprising a rigid backing layer (5) of a structural support material (5m) provided along a face (20b) of thermoformed stack opposite the carrier substrate (3), the backing layer encapsulating the electronic devices (10) and at least part of the corresponding electronic wiring (11),

9. The structural electronics module according to claim 7 or 8, wherein the carrier substrate (3) and the buffer layer (2) have a combined thickness 300-600 pm and wherein the buffer layer (2) has a thickness in a range of 50 pm to 300 pm, and whereby the substrate has a storage modulus between 10-50 MPa during thermoforming the stack.

10. The structural electronics module (1) according to any of claims 7-9, further comprising a graphic layer (4) between the carrier substrate (3) and the buffer layer (2).

11. The structural electronics module (1) according to any of claims 7-10, wherein each of the thermoplastic carrier substrate (3) and the buffer layer (2) are transparent or at least translucent for visible light.

12. The structural electronics module (1) according to any of claims 7-11, wherein the carrier substrate (3) is a polycarbonate based layer having a thickness in a range of 200-400 pm and wherein the buffer layer has a thickness in a range of 50-300 pm, whereby the buffer layer has a storage modulus ≥ 0.01 MPa at 150 °C.

13. The structural electronics module (1) according to any of claims 7-12, wherein the carrier substrate (3) is formed of a composition (3m) comprising polycarbonate and/or polymethyl methacrylate and wherein the buffer material is formed of a composition comprising polyurethane and/or polyvinyl butyral.

14. A car part (1000) comprising the module according to any to any of claims 7-13 or the module as obtainable by the method according to any of claims 1-6, wherein the carrier substrate (3) is formed of a composition (3m) comprising polycarbonate.
